## Europäisches Patentamt

## European Patent Office

## Office européen des brevets

(19)

(11) Veröffentlichungsnummer: **0 026 443**
**B1**

(12) **EUROPÄISCHE PATENTSCHRIFT**

(45) Veröffentlichungstag der Patentschrift:
'06.02.85

(51) Int. Cl.⁴: **H 05 K 7/20**

(21) Anmeldenummer: **80105731.6**

(22) Anmeldetag: **24.09.80**

(54) **Einrichtung zum Abführen der Verlustleistungswärme von in einem Schrankgestell eingebauten elektronischen Geräteeinschüben.**

(30) Priorität: **27.09.79 DE 2939088**

(43) Veröffentlichungstag der Anmeldung:
**08.04.81 Patentblatt 81/14**

(45) Bekanntmachung des Hinweises auf die Patenterteilung:
**06.02.85 Patentblatt 85/6**

(84) Benannte Vertragsstaaten:
**FR GB IT SE**

(56) Entgegenhaltungen:
**DE - A - 2 509 487**
**DE - A - 2 537 295**
**DE - A - 2 722 142**
**FR - A - 2 193 303**
**US - A - 3 833 837**
**US - A - 3 864 607**

(73) Patentinhaber: **Rohde & Schwarz GmbH & Co. KG,**
**Mühldorfstrasse 15, D-8000 München 80 (DE)**

(72) Erfinder: **Bauer, Helmut, Buchenweg 10,**
**D-8130 Niederpöcking (DE)**

(74) Vertreter: **Graf, Walter, Sckellstrasse 1,**
**D-8000 München 80 (DE)**

## Beschreibung

Die Erfindung betrifft eine Einrichtung laut Oberbegriff des Hauptanspruches.

Eine Einrichtung dieser Art ist durch die Druckschrift FR-A-2 193 303 bekannt. Diese bekannte Einrichtung dient zum Kühlen von übereinander gestapelten Schaltungskarten. Der Luftabzugskamin ist hierbei seitlich angebracht, auf der gegenüberliegenden Seite ist ein weiterer Kamin vorgesehen, der zur Schrankunterseite offen ist und in welchem die Lufteinlassöffnungen ausgebildet sind, die jeweils in den Raum zwischen den Schaltungskarten münden. Durch die Wirkung des Luftabzugskamins wird durch natürliche Konvektion Kühlluft von unten angesaugt und über die zwischen den Schaltungskarten mündenden Lufteinlassöffnungen längs dieser zum Luftabzugskamin geführt und von dort zur Schrankoberseite abgeleitet. Diese bekannte Anordnung mit einem zusätzlichen Lufteinlasskamin wäre allenfalls durch den zusätzlichen Einbau eines Gebläses für die wirksame Abfuhr der Verlustleistungswärme von elektronischen Geräteeinschüben geeignet, deren Bauelemente relativ grosse Verlustleistungswärme abgeben, wie dies beispielsweise bei den Endstufen von Hochfrequenzsendern der Fall ist. Für solche Geräte wurde deshalb bisher stets ein elektrisch angetriebenes Lüftersystem zur Wärmeabfuhr benutzt (DE-B-1 790 054 bzw. DE-A-2 006 759). Diese bekannten Lüftersysteme erfordern zusätzliche Wartung und ihre Motoren sind starkem Verschleiss ausgesetzt. Bei üblichen mit Röhren bestückten Senderanlagen war dies nicht weiter störend. In neuerer Zeit werden aber immer mehr VHF- und UHF-Sender mit weitgehendst wartungsfreien Halbleiter-Bauelementen aufgebaut, auch die bis zu 500 Watt Senderleistung abgebenden Senderstufen. Solche mit Halbleiter-Bauelementen aufgebaute Sender sind weitgehendst wartungsfrei und besitzen hohe Betriebssicherheit und für solche Sendeanlagen würden die sehr wartungsintensiven bekannten Lüftersysteme nicht mehr passen.

. Es wurde auch schon versucht, bei derartigen Anlagen die Verlustleistungswärme ausschliesslich durch natürliche Konvektion abzuführen, indem die Geräteeinschübe so im Schrankgestell befestigt werden, dass sie mit ihren geschlossenen Chassisböden die Schrankvorderseite abschliessen und ausser den daran befestigten Bauelementen keine weiteren Bauteile nach hinten in den Schrankraum abstehen und so hinter diesen Geräteeinschüben ein durchgehender Luftabzugskamin entsteht (GB-PS 787 631). Diese bekannte Anordnung wäre nicht für Schrankgestelle der eingangs erwähnten Art geeignet, bei denen die Einschübe mit ihren geschlossenen Böden horizontal übereinander angeordnet sind und mit dieser bekannten Anordnung würde auch nicht die für solche Anlagen erforderliche Kühlleistung allein durch Konvektion erreicht werden, weshalb bei dieser bekannten Anordnung am unteren Kaminende auch wieder ein zusätzlicher Lüfter vorgesehen ist.

Zur möglichst gleichmässigen Verteilung des von oben oder unten über einen Lüfter in einem Gerätegestell der Nachrichtentechnik erzeugten Kühlluftstromes auf die in horizontalen Reihen über und nebeneinander in diesem Gestell angeordneten Baugruppen ist es weiter bekannt, die Kühlluft durch einen auf der einen Seite neben den Baugruppenreihen angeordneten Zuluftkanal zuzuführen und durch einen seitlich auf der anderen Seite neben diesen Baugruppenreihen vorgesehenen Abluftkanal wieder abzuführen und zwischen den Baugruppenreihen Luftleitplatten anzubringen, durch welche voneinander getrennte Luftkanäle entstehen, von denen aus die Kühlluft an die nebeneinander angeordneten Baugruppen von unten nach oben vorbeistreichen kann (DE-OS 2 509 487). Ohne Gebläse könnte auch bei dieser bekannten Anordnung die Verlustleistungswärme nicht mit dem erforderlichen Wirkungsgrad abgeführt werden und auch diese bekannte Anordnung wäre nicht für Schrankgestelle der eingangs erwähnten Art mit horizontal übereinander angeordneten geschlossenen Einschüben geeignet.

Schliesslich ist es bekannt, an der Aussenseite von Geräteeinschubwänden, an denen zu kühlende Bauelemente befestigt sind, zusätzliche Rippenkühlkörper anzubringen (DE-A-2 722 142).

Es ist Aufgabe der Erfindung, eine im Aufbau einfache Einrichtung zu schaffen, mit der ausschliesslich durch natürliche Konvektion die Verlustleistungswärme von den in einem Schrankgestell übereinander eingebauten elektronischen Geräteeinschüben abführbar ist und die eine mit den bekannten Lüftersystemen vergleichbare Kühlleistung erbringt.

Diese Aufgabe wird ausgehend von einer Einrichtung laut Oberbegriff des Hauptanspruches durch dessen kennzeichnende Merkmale gelöst. Vorteilhafte Weiterbildungen ergeben sich aus den Unteransprüchen.

Die Kühleinrichtung, wie sie in den Ansprüchen beschrieben ist, ermöglicht mit einfachen Mitteln ohne Gebläse allein durch Konvektionskühlung die Abfuhr der Verlustleistungswärme von den Einschüben, und zwar wird allein durch die Anpassung der Querschnittsfläche der Lufteintrittsöffnungen an den Frontplatten der zu kühlenden Einschübe an die Querschnittsfläche des hinter den Einschüben vorgesehenen Abzugskamins, in welchen die jeweils horizontal unterhalb der zu kühlenden Einschübe geführten Kühlkanäle der Rippenkühlkörper münden, ein optimaler Luftzug bei erwärmten Einschüben erreicht. In der Praxis wurden Luftzugsgeschwindigkeiten von 50 cm/sec und mehr erzielt. Damit kann die auch von relativ grossen Verlustleistungen herrührende Wärme voll abgeführt werden. Wichtig für einen derart optimalen Luftdurchsatz ist lediglich, dass der Kamin von kalter Fremdluft freigehalten wird, also die Schrankrückseite gut verschlossen ist und auch die Schrankvorderseite durch die Frontplatten der keine sich erwärmenden Bauelemente aufweisenden Einschübe bzw. durch Blindfrontplatten dicht verschlossen ist und nur über die Lufteinlassöffnungen der zu kühlenden Einschübe und über die dahinter beginnenden horizontalen Luftkanäle längs der erwärmten Kühlflächen dieser Einschübe Luft zum Kamin gelangen kann. Ein weiterer Vorteil, der mit dem Anmeldungsgegenstand zu erzielen ist, ist darin zu sehen, dass die Kühlluft nur längs der Kühlkörper auf der Unterseite der Einschübe geführt wird, also nur mit diesen äusseren Kühlflächen in Berührung kommt und die elektronischen Geräte selbst nicht durch Staub verschmutzen kann. Beim Anmeldungsgegenstand ist auch eine Temperaturüberhöhung an den Frontplatten vermieden, da die zu kühlenden Bauelemente unmittelbar in gutem Wärmekontakt mit dem horizontal angeordneten Kühlkörper jeweils auf der Einschubunterseite verbunden sind. In manchen Anwendungsfällen vor allem bei nur wenig Verlustleistungswärme erzeugenden Geräteeinschüben genügt es, den Kamin allein durch die bei solchen Schränken sowieso vorgesehenen seitlichen oder rückseitigen Freiräume zu bilden und nur dafür zu sorgen, dass die Oberseite des Schrankgestelles als Kaminauslass offen ist. Der Anmeldungsgegenstand ist besonders geeignet für moderne transistorierte UKW-Sender, bei welchen je nach gewünschter Ausgangsleistung eine oder mehrere Transistorendstufen von beispielsweise jeweils 500 W Ausgangsleistung und entsprechender Verlustleistungswärme zusammen mit anderen sich im Betrieb nicht oder nur schwach erwärmenden Einschüben wie Messgeräten, Netzgeräten und dgl. in einem Schrankgestell zusammengebaut sind.

Die Erfindung wird im folgenden anhand schematischer Zeichnungen an einem Ausführungsbeispiel näher erläutert.

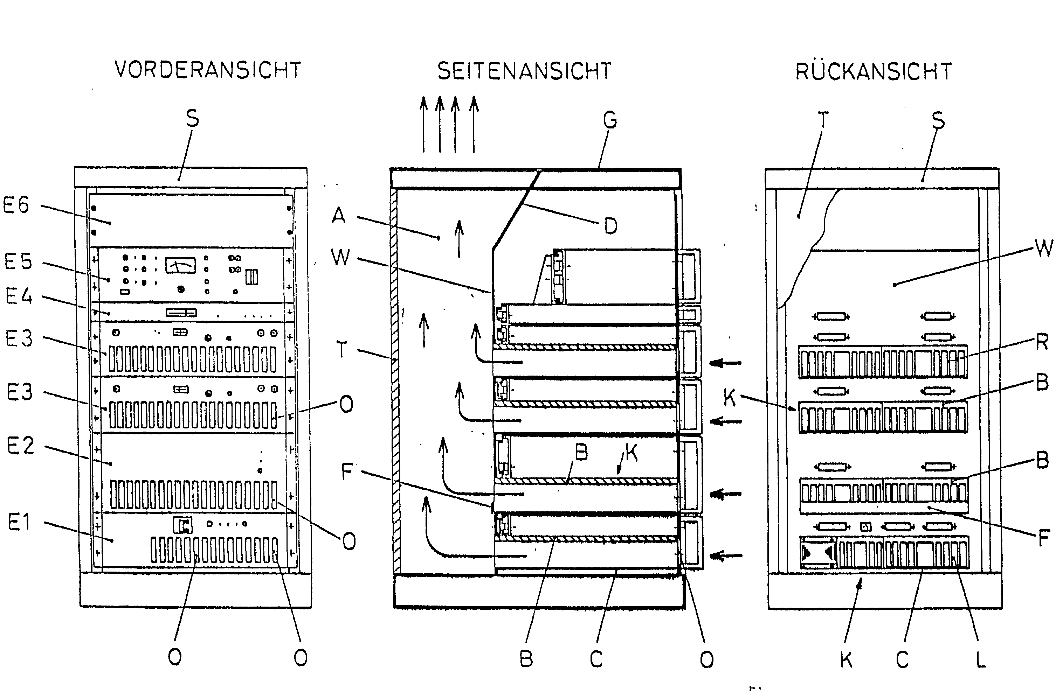

Die Figur zeigt in Vorder-, Rück- und, bei abgenommener Seitenwand, in Seitenansicht ein mit elektronischen Geräteeinschüben E bestücktes Schrankgestell S. In dem gezeigten Ausführungsbeispiel eines UKW-Senders ist im unteren Teil ein Netzgeräteeinschub E1 eingebaut, der teilweise Verlustleistungswärme erzeugt, darüber ein teilweise Verlustleistungswärme erzeugender Spannungsreglereinschub E2, gefolgt von zwei mit Leistungstransistoren bestückten und relativ grosse Verlustleistungswärme erzeugenden Senderendstufen E3. Darüber sind wieder zwei im wesentlichen kalt bleibende volltransistorierte Steuereinschübe E4 und E5 angeordnet und der obere nicht benutzte Teil des Schrankes ist mit einer Blindplatte E6 abgeschlossen. Die Vorderseite des Schrankgestelles ist damit durch die Frontplatten dieser Einschübe E1 bis E6 abgedeckt und abgedichtet.

Den Verlustleistungswärme erzeugenden Einschüben E1, E2 und E3 sind auf der Unterseite jeweils Rippenkühlkörper K zugeordnet. Diese Rippenkühlkörper K bestehen, wie dies die in der Rückansicht dargestellten Einschübe E1 bis E3 zeigen, aus einem durchgehenden horizontalen Kühlkörperboden B, der mit der Unterseite des eigentlichen zu kühlenden Einschubes in gutem Wärmekontakt steht bzw. an welchem unmittelbar die zu kühlenden Bauelemente, beispielsweise die Leistungstransistoren der Senderendstufen, befestigt sind. Von diesem Kühlkörperboden B stehen nach unten Kühlrippen R ab, die von der Frontplatte bis zur Rückseite des jeweiligen Einschubes in horizontaler Richtung verlaufen und zwischen denen horizontale Kühlkanäle L entstehen. An den Frontplatten dieser mit einem Rippenkühlkörper K ausgestatteten Einschübe E1, E2 und E3 sind jeweils Lufteintrittsöffnungen O vorgesehen, die fluchtend mit den dahinter beginnenden Kühlkanälen L angeordnet sind und etwa gleich grossen Querschnitt wie diese besitzen. Die Kühlkanäle L münden auf der Schrankrückseite in einen freien sich über die gesamte Rückseite erstreckenden Luftabzugskamin A. Der Querschnitt dieses Kamins A wird bestimmt durch die Schranktiefe bzw. die Tiefe der eingebauten Einschübe und der Schrankbreite. Dieser Kamin A ist an der Schrankoberseite offen und wird durch die rückwärtige Schranktür T, die beiden Gestellseitenwände und eine hinter den Einschüben befestigte Rückwand W gebildet, die nur an den Mündungsstellen der Kühlkanäle L entsprechende Fenster aufweist und die im oberen Bereich in eine den Austrittsquerschnitt vergrössernde trichterförmige Abdeckung D übergeht. Der Kaminauslass ist mit einem die Schrankdecke bildenden Gitter G abgedeckt. Der Querschnitt dieses Kamins A ist nach den bekannten Regeln der Kaminbaukunst so an die Summe der Querschnittsflächen der Lufteinlassöffnungen O der zu kühlenden Einschübe angepasst, dass sich eine optimale Zugwirkung einstellt. Diese Summe der Querschnittsflächen der Lufteinlassöffnungen O hängt natürlich von der Anzahl der zu kühlenden Einschübe ab, die in einem Schrank eingebaut sind. Bei der Optimierung der Kaminwirkung muss natürlich auch noch die zu erwartende Verlustleistungswärme und damit die an den Kühlkörpern zu erwartende Übertemperatur berücksichtigt werden. Wenn die gesamte Frontseite des Schrankes und auch der rückwärtige Kamin A gut abgedichtet ist, wird im Betrieb, d. h. bei erwärmten Einschüben E1 und E3 ein relativ grosser Luftzug durch die Einlassöffnungen O und die Kanäle L an den zu kühlenden Kühlkörpern vorbei in den Kamin A erzeugt, wie dies in der Seitenansicht durch die Pfeile schematisch angedeutet ist. Die im Kamin A gesammelte erwärmte Luft wird über das Gitter G nach oben abgegeben. Diese Luftzirkulation wird beim Anmeldungsgegenstand und trotz der horizontal angeordneten Kühlkörper allein durch Konvektionswärme und die Wirkung des Kamins A erreicht.

Die Rippenkühlkörper K werden vorzugsweise als standardisierte Aluminiumstrangpressprofile ausgebildet, die an der Unterseite der zu kühlenden Einschübe befestigt werden und an deren Bodenfläche die zu kühlenden Bauelemente unmittelbar angeschraubt werden können. Die vertikale Höhe der Kühlrippen R richtet sich nach den gewünschten Eintrittsquerschnitten für die Kühlkanäle L. Für grösseren Luftdurchsatz werden diese Rippen R natürlich entsprechend höher gewählt, so dass sich dann auch grössere Eintrittsquerschnitte für die Lufteinlassöffnungen O ergeben.

Optimale Luftgeschwindigkeiten lassen sich bei Konvektionskühlung nur bei weitgehendst laminarer Strömung erreichen. Turbulenzen und Verwirbelungen müssen daher soweit wie möglich vermieden werden. Aus diesem Grunde ist durch zusätzliche Abdeckbleche dafür gesorgt, dass die von unten aufsteigende erwärmte Luft nicht in die Luftkanäle L der darüberliegenden Einschübe eindringen kann. Da die Oberseite der Einschübe meist nicht geschlossen ist sondern Kühlöffnungen aufweist, ist es vorteilhaft, die Kühlkanäle L auch auf ihrer Unterseite durch ein sich über die gesamte Breite erstreckendes Abdeckblech C abzudichten, auf welchem unmittelbar die Kühlrippen R aufstehen. Dadurch werden allseits geschlossene und nur vorne und hinten offene Kühlkanäle L gebildet.

Eine einfache Möglichkeit der Anpassung des jeweiligen Kühlkanalquerschnittes an die abzuführende Verlustleistungswärme besteht darin, den Austrittsquerschnitt der Kanäle L auf der Rückseite der Einschübe durch zusätzlich abgewinkelte Abdeckbleche F zu verschliessen, wie dies für den weniger Verlustleistungswärme als die Einschübe E3 erzeugenden Einschub E2 schematisch dargestellt ist. Durch Versuche können so optimale Luftdurchsätze und damit optimale Kühlung für die jeweils unterschiedliche Verlustwärme erzeugenden übereinander angeordneten Einschübe eingestellt werden.

Sind in einem Schrank Geräteeinschübe eingebaut, die nicht gleichzeitig betrieben werden, also nicht gleichzeitig Wärme abgeben, muss zur Vermeidung von falscher Zugluft entweder dafür gesorgt werden, dass die Einlassöffnungen O bzw. Kanäle L der nicht betriebenen Geräteeinschübe verschlossen sind, oder es müssen jeweils getrennte Abzugskamine für diese Gerätegruppen vorgesehen werden, was beispielsweise durch Einbau entsprechender Trennbleche auf der Rückseite des Schrankes erfolgen kann. In solchen Fällen können beispielsweise auch die seitlichen Zwischenräume zwischen den Einschüben und den Schrankwänden als Kamine ausgenutzt werden.

**Patentansprüche**

1. Einrichtung zum Abführen der Verlustleistungswärme von in einem Schrankgestell (S) horizontal übereinander eingebauten und mit ihren Frontplatten die gesamte Schrankvorderseite abschliessenden elektronischen Geräteeinschüben (E1 bis E6) durch natürliche Konvektion mit einem zur Schrankoberseite führenden Luftabzugskamin (A) und mit Lufteinlassöffnungen (O) an der dem Luftabzugskamin gegenüberliegenden Seite, dadurch gekennzeichnet, dass an den zu kühlenden Geräteeinschüben (E1, E2, E3) jeweils in an sich bekannter Weise horizontale Rippenkühlkörper (K) angebracht sind, deren Kühlkanäle (L) von der Schrankvorderseite zur Schrankrückseite verlaufen und in den auf der Schrankrückseite ausgebildeten Abzugskamin (A) münden, dass die Lufteinlassöffnungen (O) an den Frontplatten der zu kühlenden Geräteeinschübe (E1, E2, E3) vorgesehen sind und zu den Kühlkanälen (L) der Rippenkühlkörper (K) führen.

2. Einrichtung nach Anspruch 1, dadurch gekennzeichnet, dass die Querschnittsfläche des Abzugskamins (A) und die Summe der Querschnittsflächen der Kühlkanäle (L) so gewählt sind, dass sich ein optimaler Kaminluftzug ergibt.

3. Einrichtung nach Anspruch 1 oder 2, dadurch gekennzeichnet, dass die Rippenkühlkörper (K) als Metallstrangpressteile ausgebildet und jeweils an der Unterseite der zu kühlenden Einschübe (E1, E3) so befestigt sind, dass die zu kühlenden Bauelemente mit dem durchgehenden Kühlkörperboden (B) in Wärmekontakt stehen.

4. Einrichtung nach einem oder mehreren der vorhergehenden Ansprüche, dadurch gekennzeichnet, dass der Querschnitt der einzelnen Lufteinlassöffnungen (O) etwa so gross wie der Querschnitt der sich dahinter erstreckenden Kühlkanäle (L) gewählt ist.

5. Einrichtung nach einem oder mehreren der vorhergehenden Ansprüche, dadurch gekennzeichnet, dass die Kaminauslassöffnung an der Oberseite des Schrankgestelles (S) mit einem Gitter (G) abgedeckt ist.

6. Einrichtung nach einem oder mehreren der vorhergehenden Ansprüche, dadurch gekennzeichnet, dass der Abzugskamin (A) durch die rückwärtige Schranktür (T), die Gestellseitenwände und eine die Rückseiten der Einschübe (E1 bis E6) abdeckende und nur die Kühlkanäle (L) frei lassende Rückwand (W, D), die abdichtend bis zu den Gestellseitenwänden reicht, gebildet ist.

7. Einrichtung nach einem oder mehreren der vorhergehenden Ansprüche, dadurch gekennzeichnet, dass die Querschnittsfläche der Kühlkanäle (L) durch zusätzliche Abdeckbleche (F) an die von dem zugehörigen Einschub jeweils erzeugte Verlustleistungswärme angepasst ist.

**Claims**

1. An arrangement for drawing off the heat generated by electronic rackmount devices (E1 to E6) mounted horizontally one above the other in a cabinet rack and with their front panels fully filling out the front of the cabinet, by means of natural convection with an air exhaust flue (A) leading to the top of the cabinet and with air inlet openings (O) on the side opposite to that on which the flue is located, characterized by the rackmount devices being cooled (E1, E2, E3) having mounted on them in a known manner horizontal finned cooling bodies (K) whose cooling channels (L) lead from the front to the rear of the cabinet, opening into the exhaust flue (A) built in on the rear side and the air inlet openings (O) being provided on the front panels of the rackmount devices being cooled (E1, E2, E3), and leading to the cooling channels (L) of the finned cooling bodies (K).

2. Arrangement according to Claim 1, characterized by the cross-sectional area of the exhaust flue (A) and the sum of the cross-sectional areas of the cooling channels (L) being so chosen that an optimum draught in the flue results.

3. Arrangement according to Claim 1 or 2, characterized by the finned cooling bodies (K) being formed by the extrusion of metal bars and in each case being attached to the underside of the rackmount device being cooled (E1, E3) in such a way that the components to be cooled are in heat-conducting contact with the continuous base (B) of the cooling body.

4. Arrangement according to one or more of the preceding claims, characterized by each of the air inlet openings (O) being chosen approximately as large as the cross-section of the cooling channels (L) extending out from this opening.

5. Arrangement according to one or more of the preceding claims, characterized by the flue output opening in the top of the cabinet rack (S) being covered with a grating (G).

6. Arrangement according to one or more of the preceding claims, characterized by the exhaust flue (A) being formed by the rear cabinet door (T), the side panels of the rack, and a rear panel (W, D) covering the rear sides of the rackmount units (E1 to E6) except for the openings of the cooling channels (L) and providing a seal reaching to the side panels of the rack.

7. Arrangement according to one or more of the preceding claims, characterized by the cross-sectional area of the cooling channels (L) being adapted to the heat generated by the associated rackmount devices by means of additional masking plates (F).

**Revendications**

1. Dispositif pour évacuer la chaleur perdue de boîtiers d'appareillage électronique encastrés dans un bâti d'armoire (S) horizontal, montés les uns sur les autres et avec leurs plaques frontales fermant l'ensemble de toute la partie antérieure de l'armoire qui sert les pièces électroniques (E1 à E6) par une convection naturelle avec un évent de cheminée conduisant à la partie supérieure de l'armoire (A) et avec des ouvertures d'entrée d'air (O) sur le côté opposé à l'évent de cheminée, et caractérisé en ce que: a) sur les pièces à refroidir (E1, E2, E3) sont placées chaque fois, de façon connue, des ailettes de refroidissement (K) dont les canaux de refroidissement (L) s'étendent du côté antérieur au côté postérieur de l'armoire et dans lesquels débouche l'écoulement de la cheminée (A) réalisé dans le côté postérieur de l'armoire; et b) les ouvertures (O) d'admission d'air comprimé sur les plaques frontales des pièces à refroidir (E1, E2, E3) sont prévues et conduisent aux canaux de refroidissement (L) des ailettes de refroidissement (K).

2. Dispositif suivant la revendication 1, caractérisé en ce que les surfaces transversales de la cheminée (A) et la somme des surfaces transversales des canaux de refroidissement (L) sont choisies de façon à obtenir un courant d'air optimal.

3. Dispositif suivant l'une des revendications 1 et 2, caractérisé en ce que les ailettes de refroidissement (K) ont la forme d'étireuses à boudin métallique et sont fixées sur la face inférieure des pièces (E1, E3) à refroidir, de sorte que les éléments à refroidir sont en contact de chaleur avec le réfrigérateur (B).

4. Dispositif suivant une ou plusieurs des revendications précédentes, caractérisé en ce que la section transversale des ouvertures (O) d'admission d'air comprimé est choisie à peu près aussi grande que la section transversale des canaux de refroidissement (L).

5. Dispositif suivant une ou plusieurs des revendications précédentes, caractérisé en ce que l'ouverture des voies d'écoulement de la face supérieure du bâti d'armoire (S) est recouverte d'une grille (G).

6. Dispositif suivant une ou plusieurs des revendications précédentes, caractérisé en ce que la cheminée (A) est formée à travers la porte arrière de l'armoire (T), les parois latérales et une paroi postérieure libre couvrant les côtés postérieurs des pièces (E1 à E6), et seulement les canaux (L), laissant libre la paroi postérieure (W, D), qui s'étend de manière étanche jusqu'aux parois latérales.

7. Dispositif suivant une ou plusieurs des revendications précédentes, caractérisé en ce que la surface transversale des canaux (L) est adaptée par des tôles de protection supplémentaire (F) aux pertes de chaleur produites chaque fois par intercalation.

RÜCKANSICHT

SEITENANSICHT

VORDERANSICHT

S   W   R   B   B   F   L   C   K   T   G   D   O   K   B   A   E6   E5   E4   E3   E3   E2   E1   O   F   T